# EUROPÄISCHE PATENTSCHRIFT

(11) **EP 0 630 175 B1**
(45) Veröffentlichungstag und Bekanntmachung des Hinweises auf die Patenterteilung: **09.10.1996**
(21) Anmeldenummer: 94105837.2
(22) Anmeldetag: 15.04.1994
(51) Int. Cl.: H05K 7/20, H01L 23/367

(54) **Kühlvorrichtung für eine elektrische Baugruppe**
Electrical assembly cooling device
Dispositif de refroidissement de composants électriques

(30) Priorität: 14.06.1993 DE 9308843 U
(43) Veröffentlichungstag der Anmeldung: 21.12.1994
(73) Patentinhaber: Blaupunkt-Werke GmbH, D-31139 Hildesheim (DE)
(72) Erfinder: Dobers, Michael, Dr., D-31134 Hildesheim (DE); Seyffert, Martin, Dr., D-31139 Hildesheim (DE)

(56) Entgegenhaltungen:
- PATENT ABSTRACTS OF JAPAN vol. 16, no. 318 (E-1232) 13. Juli 1992 & JP-A-04 092 461
- PATENT ABSTRACTS OF JAPAN vol. 13, no. 531 (E-851) 28. November 1989 & JP-A-01 217 998
- IBM TECHNICAL DISCLOSURE BULLETIN, Bd.25, Nr.5, Oktober 1982, New York, US, SS 2544-2546; C.W, HO AND E.E. SHAPIRO: 'Chip attachment structure for high performance, efficiently cooled semiconductor chip carriers'

## Beschreibung

Die Erfindung betrifft eine Kühlvorrichtung für eine elektrische Baugruppe (Modul) mit mindestens einem wärmeerzeugenden Bauelement, vgl. z.B. Patent Abstracts of Japan, Band 13, No 531 (E-851), 28.11.1989.

In elektronischen Geräten werden häufig einzelne Schaltungen als Baugruppen (Module) zusammengefaßt und elektrisch sowie mechanisch mit Leiterplatten - in diesem Zusammenhang auch als Mother Board bezeichnet - verbunden, welche häufig auch restliche Bauelemente, beispielsweise Stromversorgungsschaltungen sowie Ein- und Ausgangsschaltungen tragen. Zu Zwecken der Kostenverminderung, der Miniaturisierung und Verbesserung der Zuverlässigkeit wurden verschiedene Technologien zur Herstellung der Module und deren Kontaktierung mit der Leiterplatte entwickelt. So sind beispielsweise Module bekannt, deren Kontaktierung mit der Leiterplatte über eine flächige Anordnung von Lotkugeln erfolgt, die als "Ball Grid Array" oder auch "Solder Grid Array" bekannt sind. Ein Verfahren zur Herstellung von solchen Ball Grid Arrays ist in der Patentanmeldung P 43 16 007.7 der Anmelderin beschrieben.

Befinden sich in den Modulen Bauelemente mit relativ hoher Verlustleistung, so ist eine Abführung der Wärme erforderlich.

Aufgabe der vorliegenden Erfindung ist es, eine Kühlvorrichtung anzugeben, die weitgehend kostengünstig unter Anwendung der ohnehin vorgesehenen Fertigungsverfahren herstellbar ist.

Diese Aufgabe wird bei der erfindungsgemäßen Kühlvorrichtung dadurch gelöst, daß die Baugruppe auf einer Seite eines an sich plattenförmigen Kühlelements aufgebracht ist und daß die andere Seite des Kühlelements mit Hilfe von Lotkugeln mit einer Leiterplatte verbindbar ist.

Die Erfindung bewirkt einen geringen thermischen Widerstand des in dieser Weise realisierten Moduls, der mindestens durch einen der relevanten Pfade für die Wärmeableitung - nämlich die Wärmeleitung über die Lotkugeln in die Haupt-Leiterplatte (Mother Board) und die Wärmeleitung über das Kühlelement an die Luft - ausreichend klein ist. Damit kann die Abgabe der Wärme vom Kühlelement an die Umgebungsluft durch natürliche oder erzwungene Konvektion erfolgen.

Eine vorteilhafte Ausgestaltung der Erfindung besteht darin, daß über die Baugruppe hinausragende Teile des Kühlelements, vorzugsweise senkrecht zur Fläche, die die Baugruppe trägt, abgebogen sind. Dadurch wird einerseits die Wärmeabgabe an die Umgebungsluft durch Konvektion verbessert und andererseits ein zusätzlicher Flächenbedarf auf der Leiterplatte für das Kühlelement vermieden.

Eine andere vorteilhafte Ausgestaltung der Erfindung besteht darin, daß mindestens ein Teil der Lotkugeln elektrisch vom Kühlelement getrennt und mit Leitern verbunden ist, welche Anschlüsse der Baugruppe elektrisch mit der Leiterplatte verbinden. Diese Ausführungsform der Erfindung berücksichtigt in vorteilhafter Weise, daß zur mechanischen Verbindung des Moduls mit der Leiterplatte ohnehin Lotkugeln erforderlich sind, die auch bei dieser Weiterbildung gleichzeitig zur Wärmeleitung zwischen dem Kühlelement und der Leiterplatte beitragen und außerdem keine zusätzliche Fläche auf der Leiterplatte benötigen.

Im Zusammenhang mit der vorliegenden Erfindung werden die Lotkugeln als Kugeln bezeichnet, auch wenn ihre Form beim fertigen Erzeugnis von der Kugelform abweicht.

Die zur Verbindung dieser Lotkugeln mit den Anschlüssen der Baugruppe erforderlichen Leiter können im Rahmen der Erfindung verschieden ausgestaltet sein. Gemäß einer Weiterbildung der Erfindung ist hierzu vorgesehen, daß die Leiter als Leiterbahnen auf einer Folie angeordnet sind und daß die Folie das Kühlelement mindestens teilweise umschließt.

Eine vorteilhafte Ausgestaltung dieser Weiterbildung besteht darin, daß Anschlüsse der Baugruppe unmittelbar mit Leiterbahnen auf der Folie verbunden sind. Dieses hat den Vorteil, daß zur elektrischen Verbindung der Leiterplatte mit dem Modul lediglich ein Bauteil, nämlich Leiterbahn-Folie erforderlich ist.

Geeignete Leiterbahn-Folien sind auf dem Markt erhältlich und bestehen beispielsweise aus einer 25 um dicken Polyimid-Folie und ebenso starken Kupfer-Leiterbahnen. Diese Leiterbahn-Folie wird umlaufend um die als Kühlelement dienende, beispielsweise 1 mm starke Aluminium-Platte laminiert.

Je nach Anzahl der erforderlichen elektrischen Verbindungen und je nach erforderlicher thermischer Leitfähigkeit kann bei dieser Weiterbildung vorgesehen sein, daß die auf der einen Seite des Kühlelements aufliegende Folie mindestens einen Teil der Fläche der Baugruppe zum unmittelbaren thermischen Kontakt mit dem Kühlelement freigibt.

In ähnlicher Weise kann auf der anderen Seite des Kühlelements derart verfahren werden, daß sowohl Lotkugeln zur elektrischen Verbindung der Leiterbahnen mit der Leiterplatte als auch Lotkugeln zur direkten thermischen Verbindung des Kühlelements mit der Leiterplatte vorgesehen sind.

Eine Verbesserung des thermischen Kontaktes zwischen dem Kühlelement und der Leiterplatte kann jedoch auch dadurch erfolgen, daß im Bereich von mehreren Lotkugeln eine vollflächige Kupferschicht aufgebracht ist. Dieses ist möglich, wenn die mit den Lotkugeln der vollflächigen Kupferschicht verbundenen Leiterbahnen elektrisch kurzgeschlossen sein dürfen.

Häufig ist ein mechanischer Schutz der zu der Baugruppe gehörenden Bauelemente erforderlich, beispielsweise wegen freiliegender Bond-Drähte. Bei einer Weiterbildung der Erfindung ist daher vorgesehen, daß die Baugruppe mit einer wärmeleitenden Kappe versehen ist, die mit Hilfe von Lotkugeln auf der einen Seite des Kühlelements aufgebracht ist. Vorzugsweise besteht die Kappe aus einem Kappendeckel und einem Kappenring.

Wenn gemäß einer Ausführungsform der Erfindung das Kühlelement aus Kupfer besteht, kann eine Lötung mit Hilfe der Lotkugeln direkt auf der Kupferschicht erfolgen. Es kann im Rahmen der Erfindung auch vorgesehen sein, daß das Kühlelement aus Aluminium besteht und auf der anderen Seite eine Kupferschicht aufweist.

Ausführungsbeispiele der Erfindung sind in der Zeichnung anhand mehrerer Figuren dargestellt und in der nachfolgenden Beschreibung näher erläutert. Es zeigt:
- Fig. 1: ein erstes Ausführungsbeispiel in zwei Ansichten, bei welchem die Kühlflächen des Kühlelements noch nicht abgebogen sind,
- Fig. 2: das erste Ausführungsbeispiel mit abgebogenen Kühlflächen in drei Ansichten,
- Fig. 3: einen Querschnitt durch eine Kappe und
- Fig. 4: einen Querschnitt eines zweiten Ausführungsbeispiels.

Gleiche Teile sind in den Figuren mit gleichen Bezugszeichen versehen.

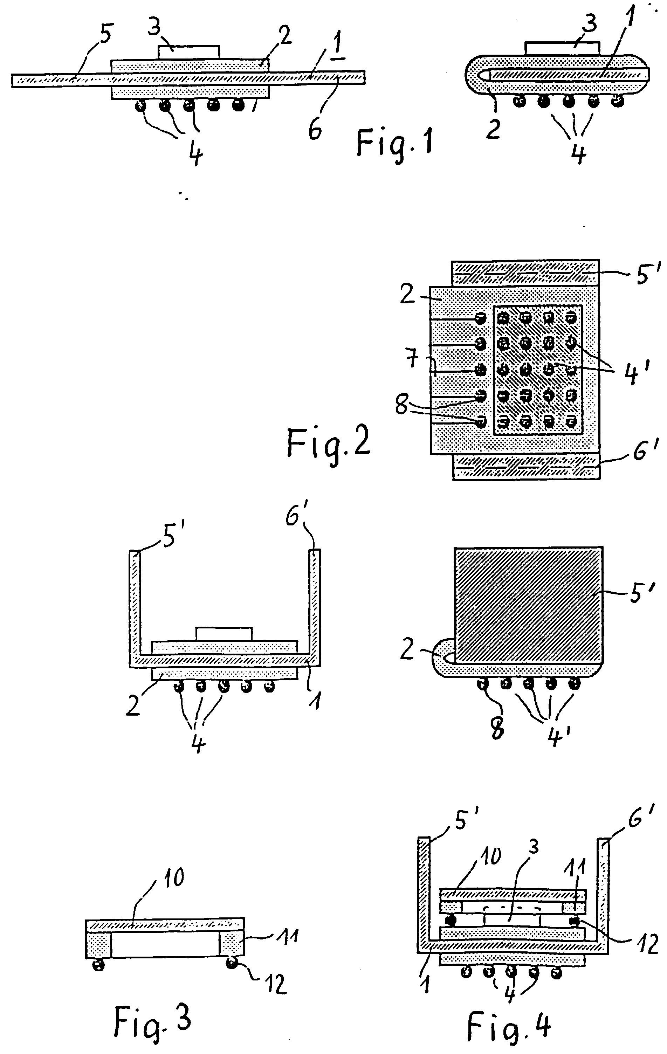

Bei dem Ausführungsbeispiel nach Fig. 1 dient eine Aluminium-Platte 1 als Kühlelement. Eine flexible Leiterbahn-Folie 2 besteht beispielsweise aus Polyimid und ist beispielsweise 25 µm stark und trägt Kupfer-Leiterbahnen, die in Fig. 1 nicht sichtbar sind. Die Leiterbahn-Folie 2 ist umlaufend um die Aluminium-Platte 1 laminiert. Auf der einen Seite - im folgenden Oberseite genannt - befinden sich die Bauelemente, von denen nur ein Bauelement 3 schematisch dargestellt ist. Auf der anderen Seite - im folgenden Unterseite genannt - sind Lotkugeln 4 zur Verbindung mit einer nicht dargestellten Leiterplatte vorgesehen.

Je nach Erfordernissen an die Wärmeleitfähigkeit und an die Zahl der elektrischen Verbindungen können die Bauelemente 3 thermisch leitend auf die Folie oder durch ein entsprechendes Loch der Folie direkt auf die Oberseite der Aluminium-Platte 1 geklebt sein. Dabei ist zur Ableitung der Verlustwärme in die Aluminium-Platte 1 der an sich geringe thermische Widerstand des verwendeten thermischen Leitklebers zu überwinden. Zusätzlich ist im ersten Fall nur der thermische Widerstand der Folie, im zweiten Fall nicht einmal dieser zu überwinden.

Die Aluminium-Platte 1 stellt wegen ihrer hohen Wärmeleitfähigkeit näherungsweise einen thermischen Kurzschluß dar, das heißt, die Aluminium-Platte liegt überall auf nahezu derselben Temperatur. Dadurch wird verhindert, daß es in dem wärmeerzeugenden Bauelement und in dessen Nähe zu einer unzulässigen Temperaturerhöhung kommt, während entferntere Teile des Moduls relativ kalt bleiben.

Aus der Aluminium-Platte 1 wird die Wärme über Konvektion an die Luft abgeführt, wobei nicht mit Folie überdeckte Teile der Aluminium-Platten als Kühlflächen 5, 6 wirken. Um eine kompaktere Form des Moduls zu erreichen und die natürliche Konvektion der Luft zu unterstützen, werden die überstehenden Teile der Aluminium-Platte hochgebogen, so daß senkrecht stehende Bleche 5', 6' (Fig. 2) entstehen. Eine weitere Abführung der Wärme aus der Aluminium-Platte 1 erfolgt über die Lotkugeln 4 von der Unterseite zur nicht dargestellten Leiterplatte.

Bei dem in Fig. 2 dargestellten Ausführungsbeispiel werden zur elektrischen Verbindung des Moduls 3 mit der Leiterplatte nur wenige Leiterbahnen 7 und Lotkugeln 8 benötigt. Die lediglich zur Wärmeableitung dienenden Lotkugeln 4' sind daher auf eine gemeinsame vollflächige Kupfer-Leiterbahn 9 gesetzt, wodurch die für den Wärmeübergang durch die Leiterbahn-Folie maßgebliche Fläche im Vergleich zu einzelnen Leiterbahnen erhöht wird.

Damit sich bei der Herstellung der erfindungsgemäßen Kühlvorrichtung Lotkugeln bilden, ist es erforderlich, die jeweils mit Lot zu benetzenden Flächen zu beschränken. Dieses kann durch Löcher in einem aufgebrachten Lötstopplack oder durch die Struktur der Leiterbahnen bzw. Kupferschichten erfolgen.

Fig. 3 zeigt einen Querschnitt durch eine Kappe, welche gleichzeitig als Schutz der Bauelemente und zur Wärmeableitung dient. Bei dem in Fig. 3 dargestellten Ausführungsbeispiel besteht die Kappe aus einer Aluminium-Scheibe 10 und einem galvanisch-verkupferten Ring 11 aus FR4. An der Unterseite des Ringes befinden sich Lotkugeln 12, die zur Befestigung und zur Wärmeableitung vom Ring 11 bzw. der Kappe dienen.

Fig. 4 zeigt eine vollständige Kühlvorrichtung nach Fig. 2, welche durch eine Kappe nach Fig. 3 erweitert ist.

## Patentansprüche

1. Kühlvorrichtung für eine elektrische Baugruppe mit mindestens einem wärmeerzeugenden Bauelement, dadurch gekennzeichnet, daß die Baugruppe (3) auf einer Seite eines an sich plattenförmigen Kühlelements (1) aufgebracht ist und daß die andere Seite des Kühlelements mit Hilfe von Lotkugeln (4, 4', 8) mit einer Leiterplatte verbindbar ist.

2. Kühlvorrichtung nach Anspruch 1, dadurch gekennzeichnet, daß über die Baugruppe (3) hinausragende Teile (5', 6') des Kühlelements, vorzugsweise senkrecht zur Fläche, die die Baugruppe (3) trägt, abgebogen sind.

3. Kühlvorrichtung nach einem der Ansprüche 1 oder 2, dadurch gekennzeichnet, daß mindestens ein Teil der Lotkugeln (8) elektrisch vom Kühlelement (1) getrennt und mit Leitern (7) verbunden ist, welche Anschlüsse der Baugruppe (3) elektrisch mit der Leiterplatte verbinden.

4. Kühlvorrichtung nach Anspruch 3, dadurch gekennzeichnet, daß die Leiter als Leiterbahnen (7) auf einer Folie (2) angeordnet sind und daß die Folie (2) das Kühlelement (1) mindestens teilweise umschließt.

5. Kühlvorrichtung nach Anspruch 4, dadurch gekennzeichnet, daß Anschlüsse der Baugruppe (3) unmittelbar mit Leiterbahnen (7) auf der Folie (2) verbunden sind.

6. Kühlvorrichtung nach einem der Ansprüche 4 oder 5, dadurch gekennzeichnet, daß die auf der einen Seite des Kühlelements aufliegende Folie mindestens einen Teil der Fläche der Baugruppe zum unmittelbaren Kontakt mit dem Kühlelement freigibt.

7. Kühlvorrichtung nach einem der vorhergehenden Ansprüche, dadurch gekennzeichnet, daß sowohl Lotkugeln zur elektrischen Verbindung der Leiterbahnen mit der Leiterplatte als auch Lotkugeln zur direkten thermischen Verbindung des Kühlelements mit der Leiterplatte vorgesehen sind.

8. Kühlvorrichtung nach einem der vorhergehenden Ansprüche, dadurch gekennzeichnet, daß im Bereich von mehreren Lotkugeln (4') eine vollflächige Kupferschicht aufgebracht ist.

9. Kühlvorrichtung nach einem der vorhergehenden Ansprüche, dadurch gekennzeichnet, daß die Baugruppe (3) mit einer wärmeleitenden Kappe (10, 11) versehen ist, die mit Hilfe von Lotkugeln (12) auf der einen Seite des Kühlelements (1) aufgebracht ist.

10. Kühlvorrichtung nach Anspruch 9, dadurch gekennzeichnet, daß die Kappe aus einem Kappendeckel (10) und einem Kappenring (11) besteht.

11. Kühlvorrichtung nach einem der vorhergehenden Ansprüche, dadurch gekennzeichnet, daß das Kühlelement (1) aus Kupfer besteht.

12. Kühlvorrichtung nach einem der Ansprüche 1 bis 10, dadurch gekennzeichnet, daß das Kühlelement (1) aus Aluminium besteht und auf der anderen Seite eine Kupferschicht aufweist.

## Claims

1. Cooling device for an electrical assembly having at least one heat-generating component, characterized in that the assembly (3) is fitted on one side of a cooling element (1) which intrinsically has the form of a plate, and in that the other side of the cooling element can be connected to a printed circuit board with the aid of solder balls (4, 4', 8).

2. Cooling device according to Claim 1, characterized in that parts (5', 6') of the cooling element which project beyond the assembly (3) are bent away, preferably at right angles to the surface which carries the assembly (3).

3. Cooling device according to either of Claims 1 and 2, characterized in that at least some of the solder balls (8) are electrically isolated from the cooling element (1) and are connected to conductors (7) which electrically connect terminals of the assembly (3) to the printed circuit board.

4. Cooling device according to Claim 3, characterized in that the conductors are arranged as conductor tracks (7) on a sheet (2), and in that the sheet (2) at least partially encloses the cooling element (1).

5. Cooling device according to Claim 4, characterized in that terminals of the assembly (3) are directly connected to conductor tracks (7) on the sheet (2).

6. Cooling device according to either of Claims 4 and 5, characterized in that the sheet resting on one side of the cooling element allows at least part of the surface of the assembly to make direct contact with the cooling element.

7. Cooling device according to one of the preceding claims, characterized in that provision is made both of solder balls for the electrical connection of the conductor tracks to the printed circuit board and of solder balls for the direct thermal connection of the cooling element to the printed circuit board.

8. Cooling device according to one of the preceding claims, characterized in that a whole-area copper layer is applied in the region of a plurality of solder balls (4').

9. Cooling device according to one of the preceding claims, characterized in that the assembly (3) is provided with a heat-conducting cap (10, 11), which is fitted on one side of the cooling element (1) with the aid of solder balls (12).

10. Cooling device according to Claim 9, characterized in that the cap is composed of a cap cover (10) and a cap ring (11).

11. Cooling device according to one of the preceding claims, characterized in that the cooling element (1) is composed of copper.

12. Cooling device according to one of Claims 1 to 10, characterized in that the cooling element (1) is composed of aluminium and has a copper layer on the other side.

## Revendications

1. Dispositif de refroidissement pour un sous-ensemble électrique avec au moins un composant qui produit de la chaleur,
caractérisé en ce que
le composant (3) est mis sur une face d'un élément de refroidissement (1) ayant en soi une forme de plaque, et en ce que l'autre face de l'élément de refroidissement peut être reliée à une carte de circuit imprimé à l'aide de globules de brasage (4, 4', 8).

2. Dispositif de refroidissement selon la revendication 1,
caractérisé en ce que
des parties (5', 6') de l'élément de refroidissement qui font saillie sur le composant (3), sont repliées de préférence perpendiculairement à la face qui porte le composant (3).

3. Dispositif de refroidissement selon l'une des revendications 1 ou 2,
caractérisé en ce que
au moins une partie des globules de brasage (8) est séparée de l'élément de refroidissement (1) et est reliée à des conducteurs (7) qui relient électriquement des raccords du composant (3) à la carte de circuit imprimé.

4. Dispositif de refroidissement selon la revendication 3,
caractérisé en ce que
les conducteurs sont disposés sous la forme de pistes conductrices (7) sur une feuille (2) et en ce que la feuille (2) entoure l'élément de refroidissement (1) au moins en partie.

5. Dispositif de refroidissement selon la revendication 4,
caractérisé en ce que
des raccords du composant (3) sont directement reliés à des pistes conductrices (7) sur la feuille (2).

6. Dispositif de refroidissement selon l'une des revendications 4 ou 5,
caractérisé en ce que
la feuille qui se trouve sur l'une des faces de l'élément de refroidissement libère au moins une partie de la surface du composant pour fournir un contact direct avec l'élément de refroidissement.

7. Dispositif de refroidissement selon l'une des revendications précédentes
caractérisé en ce que
l'on prévoit des globules de brasage servant à relier électriquement les pistes conductrices à la carte de circuit imprimé comme aussi des globules de brasage servant à la liaison thermique directe de l'élément de refroidissement avec la carte de circuits imprimés.

8. Dispositif de refroidissement selon l'une des revendications précédentes,
caractérisé en ce que
dans la zone de plusieurs globules de brasage (4') on met une couche de cuivre sur toute la surface.

9. Dispositif de refroidissement selon l'une des revendications précédentes,
caractérisé en ce que
le composant (3) est pourvu d'un chapeau thermoconducteur (10, 11) qui est placé, à l'aide de globules de brasage (12), sur l'un des côtés de l'élément de refroidissement (1).

10. Dispositif de refroidissement selon la revendication 9,
caractérisé en ce que
le chapeau consiste en un couvercle (10) et en une bague (11).

11. Dispositif de refroidissement selon l'une des revendications précédentes,
caractérisé en ce que
l'élément de refroidissement (1) est réalisé en cuivre.

12. Dispositif de refroidissement selon l'une des revendications 1 à 10,
caractérisé en ce que
l'élément de refroidissement (1) est réalisé en aluminium et présente sur l'autre face une couche de cuivre.
